# FASCICULE DE BREVET EUROPEEN

(11) **EP 0 671 705 B1**
(45) Date de publication et mention de la délivrance du brevet: **01.10.2003**
(21) Numéro de dépôt: 95400305.9
(22) Date de dépôt: 14.02.1995
(51) Int. Cl.: G06K 19/077

(54) **Procédé de fabrication d'une carte hybride**
Herstellungsverfahren einer Kombi-Karte
Manufacturing process for a hybrid card

(30) Priorité: 14.02.1994 FR 9401652
(43) Date de publication de la demande: 13.09.1995
(60) Demande divisionnaire: 03008639.1
(73) Titulaire: GEMPLUS, 13881 Gémenos Cédex (FR)
(72) Inventeur: Fidalgo, Jean-Christophe, F-75116 Paris (FR)

(56) Documents cités:
- EP-A- 0 570 062
- WO-A-87/02806
- WO-A-88/08592
- WO-A-93/20537
- DE-A- 4 105 869
- FR-A- 2 659 767

## Description

L'invention concerne un procédé de fabrication d'une carte hybride comportant un corps de carte, un module électronique et, connectée au module, une antenne. De telles cartes sont destinées à la réalisation d'opérations, telles que de débit dans des véhicules de transport en commun et notamment dans le métro, bancaires, téléphoniques, ou d'identification. Ces opérations s'effectuent grâce à un couplage électromagnétique à distance.

Le corps de carte est constitué d'un assemblage de feuilles thermoplastiques et d'un module électronique comprenant une puce à circuit intégré. Une antenne du type bobine d'inductance est connectée à la puce.

La réalisation de cartes sans contact par colamination, consiste à disposer, entre les deux plateaux d'une presse, un empilement de feuilles thermoplastiques au milieu duquel on positionne le module électronique sans contact déjà connecté à une antenne qui entoure le module. On effectue ensuite le soudage des différentes feuilles thermoplastiques en appliquant pression et température.

Du fait des différences de coefficient de dilatation entre les matériaux utilisés, l'action combinée de la pression et de la température engendre une déformation résiduelle à la surface de la carte et en regard du module électronique. Des zones de résistance différentielle aux chocs et aux torsions sont créées. La carte obtenue n'est pas esthétique, à moins d'augmenter l'épaisseur de la carte, ce qui ne permet pas, bien souvent, d'atteindre l'épaisseur de 0,76 mm précitée. Le rendement de tels procédés est faible. En plus, comme les cartes rejetées contiennent déjà le module électronique et la bobine, ces procédés sont particulièrement coûteux. Dans d'autres procédés de réalisation de cartes sans contact : on dépose un cadre rectangulaire sur une feuille thermoplastique inférieure, on dépose un module électronique, déjà connecté à une antenne, à l'intérieur d'une cavité formée par le cadre et la feuille intérieure, puis on coule une résine thermodurcissable dans cette cavité, avant de recouvrir cette dernière d'une feuille thermoplastique supérieure.

Les cartes réalisées ainsi présentent, sur la tranche, une bande sinusoïdale inesthétique. De plus, le positionnement du module à l'intérieur de la carte n'est qu'approximatif. il est donc particulièrement difficile d'ajouter une interface à contact aux cartes réalisées par ces procédés.

Le document DE-A-4105869 Schneider décrit une carte hybride comportant un corps, un module avec une puce, et plusieurs plages de contact, ainsi qu'une antenne reliée aux plages de contact du module par l'intermédiaire de deux bornes de contact. Le module comporte en outre des plots de contact pour un fonctionnement par contact.

Le document WO-A-8808592 SoundCraft décrit la fabrication d'une carte sans contact, où on ménage dans une couche du corps une cavité à l'intérieur de laquelle. Un module fixé à l'antenne est placé sur la couche du corps. Ces couche, module et antenne sont ensuite colaminées.

Le document WO-A-9320537 Pikopak décrit la connexion d'une antenne à un module, grâce à un raccord dit "socket", puis un surmoulage après encapsulation par co-laminage entre deux feuilles plastique.

Le document EP-A-0570062 Nedap décrit un corps ayant suivant son épaisseur trois couches comportant des évidements qui permettent après assemblage de ces couches, la formation d'une cavité d'introduction d'un module. La cavité permet aussi l'enroulement d'un fil d'antenne.

Le document FR-A-2659767 Nsi décrit une carte comportant deux bornes de connexion auxquelles une puce est connectée par des fils.

Le document WO-A-8702806 Artacho décrit une puce logée dans une ouverture d'un corps de carte.

L'invention a pour but de proposer un procédé de fabrication de cartes hybride qui pallie les inconvénients précités, et qui permette en particulier d'obtenir aisément des cartes esthétiques de faible épaisseur, avec un bon rendement, à un moindre coût, et en minimisant l'imprécision du report du module électronique dans le corps de carte.

A cet effet, l'invention est décrite dans les revendications.

La description qui va suivre et qui ne présente aucun caractère limitatif, permettra de mieux comprendre la manière dont l'invention peut être mise en pratique.

Elle doit être lue en regard des dessins annexés, dans lesquels :
- la figure 1 montre, en coupe transversale, une carte sans contact hybride selon l'invention obtenue selon le procédé de l'invention ;
- la figure 2 illustre, en vue de dessus, une étape du procédé de l'invention dans laquelle on dispose une antenne sur une feuille thermoplastique du corps de carte d'une carte selon l'invention ;
- la figure' 3 illustre, en coupe transversale, l'étape précitée ainsi que l'antenne disposée sur une feuille thermoplastique du corps de carte de l'invention ;
- la figure 4 illustre, en vue de dessus, une étape du procédé de l'invention dans laquelle on dépose une couche thermoplastique sur un ensemble feuille thermoplastique-antenne, selon un premier mode de réalisation d'une carte de l'invention ;
- la figure 5 illustre l'étape précitée, en coupe transversale, ainsi qu'une étape de report du module dans une cavité d'une carte sans contact hybride de l'invention ;
- la figure 6 illustre, en vue de dessus, une étape du procédé de l'invention dans laquelle on dépose une couche thermoplastique sur un ensemble feuille thermoplastique-antenne, selon un second mode de réalisation d'une carte hybride de l'invention ;
- la figure 7 illustre l'étape précitée, en coupe transversale, ainsi qu'une étape de report du module dans une cavité d'une carte hybride selon l'invention ;
- la figure 8 représente, en vue de dessus, un micromodule d'une carte hybride selon l'invention ; et
- la figure 9 représente, une coupe transversale selon A-A du micromodule d'une carte hybride selon l'invention représenté en figure 8.

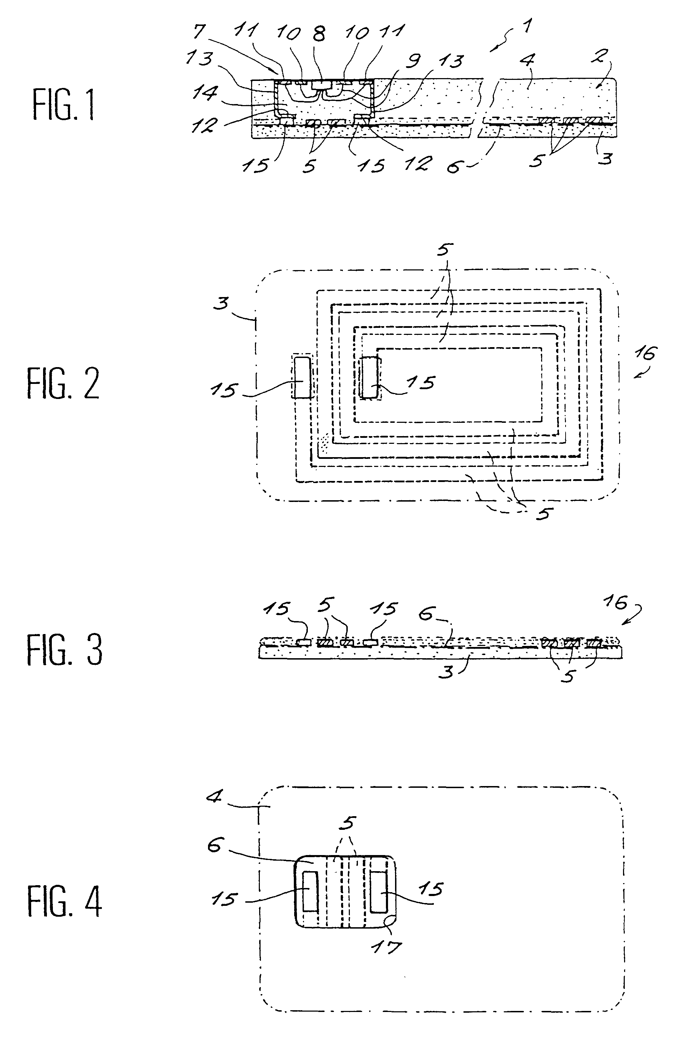

La figure 1 montre, en coupe transversale, une carte sans contact hybride obtenue selon le procédé de l'invention. Cette carte est référencée 1 dans son ensemble. Une telle carte 1 possède la faculté de fonctionner selon les deux modalités : sans contact et par contacts.

Ces cartes hybrides sont destinées, par exemple, à des opérations du type télébillétique, dans lesquelles elles sont débitées à distance d'un certain nombre d'unités lorsqu'elles passent au voisinage d'une borne (fonctionnement sans contact), et dans lesquelles elles sont rechargées dans un distributeur compatible avec les cartes à contacts standards (fonctionnement par contacts).

Les cartes sans contact hybrides comportent donc une interface à contacts comportant, par exemple, par des plots superficiels formant des métallisations. Ces plots sont connectés à la puce en vue de la réalisation d'opérations par contacts ou sans contact.

Dans la présente description, on appellera carte sans contact, une carte ayant un fonctionnement exclusivement sans contact, ou alors, une carte ayant un fonctionnement hybride.

Une carte 1 comporte un corps de carte 2 composé d'une feuille thermoplastique inférieure 3 et d'une couche thermoplastique supérieure 4. Elle comporte en outre une antenne 5, disposée au dessus de la feuille 3. Cette antenne 5 est éventuellement noyée dans une couche de colle 6 représentée en traits tirés sur la figure 1.

La carte 1 comporte en outre un module électronique hybride 7, situé dans la couche 4, au dessus de l'antenne 5.

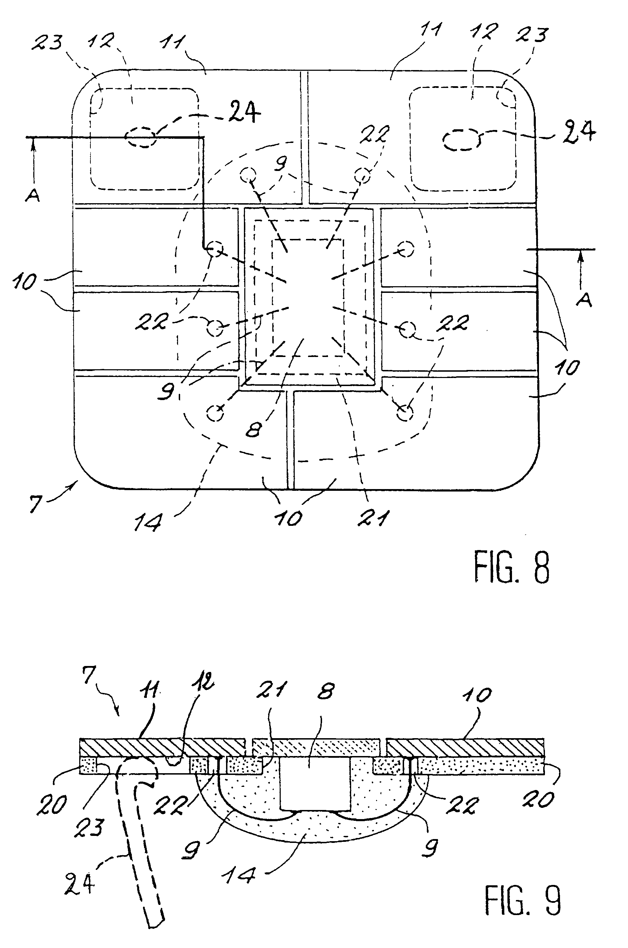

Ce module électronique 7 est décrit, en particulier, au regard des figures 8 et 9. Il comprend une puce à circuits intégrés 8 connectée électriquement, par l'intermédiaire de fils conducteurs de connexion 9, directement à un ensemble de plots métalliques 10 et 11 constitués, par exemple, de cuivre, et formant des métallisations. Les plots 10 et 11, dans un exemple au nombre de huit, sont situés au-dessus de la puce 8 et affleurent à la surface de la carte 1. Ils sont disposés sur la carte 1 de façon à respecter la norme ISO 7816 définissant le positionnement des contacts d'une carte à puce. Ils sont contrecollés, sur leur face inférieure, avec un diélectrique 20 qui peut être du verre/époxy, du polyester, du polyimide ou tout autre film polymère adapté. La puce 8 est collée dans une fenêtre 21 centrale ménagée dans le diélectrique 20. La connexion des plots 10, 11 à la puce 8 est effectuée, par les fils 9, au travers de puits 22 ménagés dans le diélectrique 20.

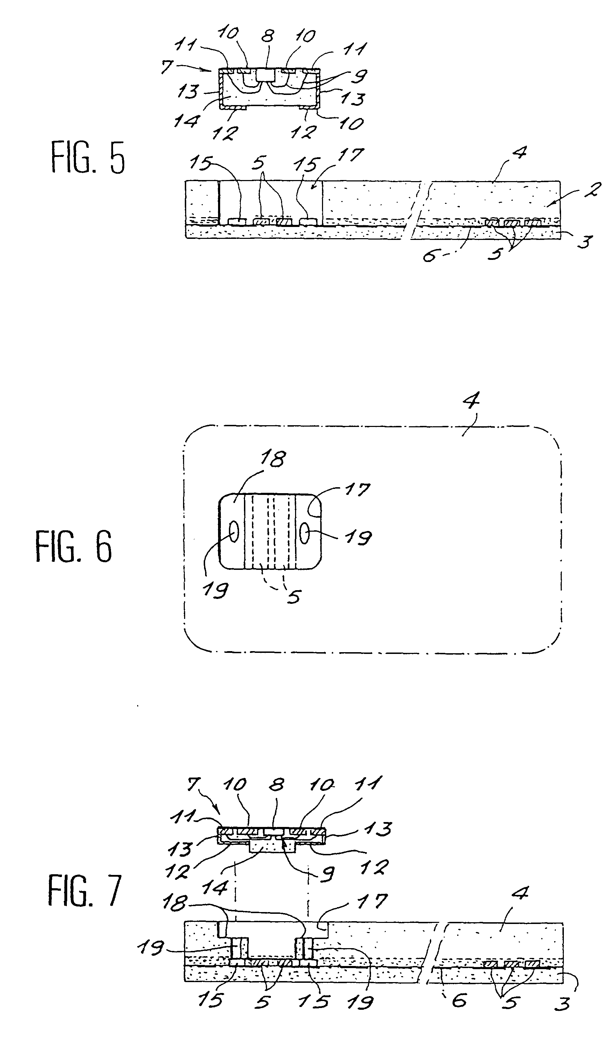

D'autre part, deux ouvertures 23 sont pratiquées dans le diélectrique 20 situé au-dessous des plots 11. Chaque ouverture 23 permet de réaliser une connexion d'une plage de contact 12 d'un desdits plots 11 avec une borne de contact 15 de l'antenne 5. Dans le cas des figures 7 et 8, les plages de contact 12 des plots 11 sont formées par les faces inférieures de ceux-ci. Lorsque cela n'est pas le cas, les plots 11 sont connectés, par exemple, à deux plages de contact métalliques inférieures 12 du module 7 par des fils conducteurs non représentés, ou alors, par une bande conductrice qui serait disposée verticalement sur des faces latérales 13 du module 7, pliée en ses extrémités, en vue de connecter efficacement les plots 11 et les plages 12 (figures 5 et 7). Les plages de contact 12 du module 7 sont en contact électrique avec les deux bornes de contact 15 de l'antenne 5. Ce contact peut être direct, réalisé par l'intermédiaire d'une résine conductrice ou par tout autre moyen conducteur et notamment, par une languette métallique à effet ressort 24.

Par ailleurs, le module 7 comprend une résine de protection 14, dans laquelle sont figés différents éléments précités, notamment la puce 8 et les fils de connexion 9.

Afin de réaliser une telle carte, le procédé de l'invention propose de disposer préalablement l'antenne 5 sur la feuille thermoplastique 3, de manière à former un ensemble 16 : feuille thermoplastique-antenne. Cette première étape est illustrée aux figures 2 et 3.

L'antenne 5 est formée d'un diélectrique métallisé ou contre-collé avec du métal, d'une feuille de métal, ou d'une bobine de fils. Elle peut être réalisée par différentes méthodes, et notamment et respectivement, en étant gravée chimiquement, par estampage, ou par bobinage d'un fil. Elle peut être réalisée par le dépôt d'un promoteur d'adhérence sur la feuille thermoplastique 3 par sérigraphie puis métallisation par dépôt chimique. Sur la figure 2, l'antenne 5 est disposée sur une face de la feuille 3 sous la forme d'une spirale 5 à trois spires dont les deux extrémités, c'est-à-dire les bornes de contact 15, sont localisées en regard et à proximité l'une de l'autre, l'une à l'intérieur et l'autre à l'extérieur de ladite spirale. L'antenne 5 peut avoir une configuration géométrique quelconque. Le nombre de spires est donné à titre seulement indicatif. En outre, la feuille peut être métallisée double face et, dans ce cas, il peut y avoir des spires sur l'autre face. Pour cette réalisation, on établit selon la technique des circuits imprimés double faces les trous métallisés de passage d'une face à l'autre. On peut alors supprimer la contrainte d'avoir à passer toutes les spires entre les bornes de contact 15. Plutôt que d'avoir des circuits double face on peut, par plusieurs opérations de sérigraphie successives, définir des spires multicouches. Par ailleurs, dans le cas où l'antenne 5 est une antenne hyperfréquences, sa configuration peut être rectangulaire à deux faces. Dans ce cas, l'antenne hyperfréquences comporte une bande de cuivre sur sa face supérieure. De plus, un trou métallisé relie électriquement la face inférieure à la face supérieure. Une extrémité de la bande de cuivre ainsi que le trou métallisé peuvent, dans cet exemple d'antenne hyperfréquences, constituer les bornes de contact 15. Quelque soit sa configuration géométrique, l'antenne 5 doit pouvoir être réalisée dans l'épaisseur de la carte 1. Elle épouse, par son contour extérieur, sensiblement et de préférence, les contours extérieurs de la feuille 3. Sa portée et ses capacités de réception, qui dépendent de la surface de flux magnétique qu'elle couvre, seront ainsi maximales. C'est la raison pour laquelle la spirale 5 est, comme la carte 1, rectangulaire.

La feuille thermoplastique 3 a sensiblement la longueur et la largueur de la carte que l'on veut obtenir. Elle sera en fait légèrement plus petite de façon à ce que l'on puisse le positionner dans un moule faisant un certain jeu latéral. Son épaisseur est moindre : elle est de l'ordre de 180 micromètres pour une carte standard correspondant à la norme ISO 7810. Cette feuille 3 est composée, par exemple, de PVC (chlorure de polyvinyl), de PC (polycarbonate), d'ABS (acrylonitrile-butadiène-styrène), de PET (polyethylène), de PETG (téréphtalate de polyéthylène glycol), de PVDF (polyfluorure de vinylidène) ou de tout autre film thermoplastique de propriétés équivalentes.

L'antenne 5, disposée sur la feuille de thermoplastique 3, peut être fixée par collage.

L'antenne 5 peut être avantageusement enduite et noyée dans de la colle thermoactivable référencée 6 en figure 3. La fixation de l'antenne 5 sur la feuille 3 est ainsi améliorée. Dans ce cas, les bornes de contact 11 de l'antenne 5 ne seront pas enduites, ce qui permettra de les connecter avec le module 7. Dans un certain nombre de cas, cette enduction ne sera pas nécessaire, l'adhérence étant alors obtenue, par exemple, par le ramollissement de la matière thermoplastique apparaissant aux températures de mise en oeuvre de l'invention considérées.

Selon une autre étape du procédé de l'invention illustrée dans les figures 4 à 7, on recouvre l'ensemble feuille thermoplastique-antenne 16, à l'exception des bornes de contact 15, de la couche thermoplastique 4.

Cette étape est avantageusement réalisée par surmoulage. En ce qui concerne la matière utilisée en vue de la fabrication de la couche 4, on utilisera volontiers de l'ABS, un PC, de l'ABS/PC, du PET ou un polyamide. Le moule utilisé comporte alors avantageusement un dispositif permettant de plaquer l'ensemble 16, de manière à ce que, pendant l'injection du thermoplastique destiné à former la couche 4, la feuille 3 reste parfaitement en position, plaquée contre l'une des faces du moule. Ce dispositif est formé, par exemple, d'une pompe d'aspiration reliée à de petits orifices percés directement dans la face du moule visée ci-dessus.

Par ailleurs, le moule utilisé comporte un ou des noyaux qui couvrent les bornes de contact 15 de l'antenne 5 et qui réservent la place du module 7. De cette manière, on forme une cavité 17 (figures 4 à 7), dont les dimensions sont voisines des dimensions du module 7. Ce noyau exerçant une pression suffisamment forte contre les bornes de contact 15, celles-ci ne seront pas recouvertes par la couche 4 et elles apparaîtront naturellement au fond de la cavité 17. Selon la conformation du noyau utilisé, la cavité 17 peut prendre un relief quelconque. Les figures 4 et 6 présentent deux types de cavités à section rectangulaire, particulièrement adaptées à recevoir des modules parallélépipèdiques. Néanmoins, ces cavités 17, présentées aux figures 4 et 6, ont une découpe différente. En effet, la cavité 17 présentée en figure 5 a⁻ une découpe parallélépipédique à fond plat, alors que la cavité 17 présentée en figure 7 montre des épaulements définissant un plan 18, traversé par deux ouvertures verticales 19 de section oblongue qui débouchent sur les bornes de contact 15.

Selon une autre étape encore du procédé de l'invention, on reporte le module électronique 7 dans la cavité 17 du corps de carte 2. Cette étape est illustrée aux figures 5 et 7. On notera cependant que, dans le cas de la réalisation d'une carte sans contact mixte, le positionnement de l'interface à contacts connectée au module sans contact est particulièrement délicat à mettre en oeuvre. En effet, le module sans contact n'est pas, bien souvent, reporté dans le corps de carte avec suffisamment de précision pour permettre une connexion convenable et automatisée de l'interface à contact.

Bien entendu, l'invention ne se limite pas au report d'un module électronique déjà complet dans la cavité 17. Par exemple, on peut procéder différemment en reportant, dans la cavité 17, la puce 8 nue. Les deux plages de contact 12 seront alors connectées aux bornes de contact 15 de l'antenne 5 avant le report de la puce 8. Les connexions aux plots 10 et 11, reportées en dernier lieu, seront effectuées après le report de la puce 8, de manière à ce que les extrémités des fils conducteurs soient prêts à recevoir les métallisations.

En figure 5, le module 7 est parallélépipédique. La cavité 17, qui lui est complémentaire, comporte en son fond, à des côtés opposés, les plages de contact 12. Lors du report du module 7 dans la cavité 17, les deux plages de contact 12 du module 7, viennent directement au contact des bornes de contact 15 de l'antenne 5. Le module 7 est fixé dans le fond de la cavité 17, par exemple, par une colle cyanoacrylate ou une colle thermoactivable ou un adhésif à froid, et à l'endroit des connexions, par exemple, par quelques gouttes de colle conductrice à base d'un époxy ou d'un acrylate chargé en argent par exemple.

En figure 7, les plages de contact 12 du module 7 sont disposées dans la partie supérieure de ce module, à proximité des métallisations. Les faces latérales verticales 13 sont réduites par rapport à la hauteur du module 7. Dans un exemple, les plages de contact sont constituées par l'envers de la grille de métallisation conduisant à la réalisation des connexions métalliques. Lors du report du module 7 dans la cavité 17, les plages de contact 12 du module 7 vont venir reposer sur le plan 18. Afin d'assurer une liaison électrique ou une connexion entre ces plages 12 et les bornes 15, on introduit les moyens conducteurs 24 dans les ouvertures 19. Aussi les ouvertures 19 sont remplies d'un polymère conducteur tel qu'une pâte à braser, ou une colle conductrice. On peut aussi disposer dans les ouvertures 19, des languettes ou ressorts métalliques. Le module 7 sera fixé dans la cavité 17 par une colle à base de, par exemple, cyanoacrylate, ou alors par un adhésif à froid ou thermoactivable.

## Revendications

1. Procédé de fabrication d'une carte hybride (1) comportant un corps de carte (2), un module électronique (7) comprenant une puce à circuit intégré (8) et deux plages de contact (12), et une antenne (5) reliée aux plages de contact (12) dudit module (7) par l'intermédiaire de deux bornes de contact (15), **caractérisé en ce qu'**il comporte une étape selon laquelle on surmoule une couche (4) du corps de carte (2) sur l'antenne (5) et on ménage, dans ladite couche (4), une cavité (17) laissant apparaître lesdites bornes de contact (15) de l'antenne (5), suivie d'une étape selon laquelle on reporte le module électronique (7) dans la cavité (17) du corps de carte (2).

2. Procédé selon la revendication 1, **caractérisé en ce qu'**on dispose préalablement l'antenne (5) sur une feuille thermoplastique (3) du corps de carte (2) de manière à former un ensemble (16) : feuille thermoplastique-antenne.

3. Procédé selon la revendication 2, **caractérisé en ce que** l'antenne est disposée sur la feuille thermoplastique (3) sous la forme d'une spirale dont les extrémités, c'est-à-dire les bornes de contact (15), sont localisées en regard l'une de l'autre, l'une à l'intérieur et l'autre à l'extérieur de ladite spirale.

4. Procédé selon la revendication 2 ou 3, **caractérisé en ce que** l'antenne (5) disposée sur la feuille de thermoplastique (3) est fixée sur ladite feuille (3) par collage.

5. Procédé selon l'une des revendications 2 ou 3, **caractérisé en ce que** l'antenne (5) est disposée sur la feuille thermoplastique (3) par le dépôt d'un promoteur d'adhérence sur ladite feuille thermoplastique (3) par sérigraphie puis métallisation par dépôt chimique.

6. Procédé selon l'une quelconque des revendications précédentes, **caractérisé en ce qu'**on enduit l'antenne (5), à l'exception de ces bornes de contact (15), d'une colle thermoactivable (6).

7. Procédé selon l'une des revendications précédentes, **caractérisé en ce que** la couche (4) est surmoulée sur l'ensemble (16) feuille thermoplastique-antenne par moulage en utilisant un moule comportant un noyau recouvrant les bornes de contact (15) de l'antenne (5).

8. Procédé selon l'une quelconque des revendications précédentes, **caractérisé en ce qu'**on forme la cavité (17) avec un plan (18) percé d'ouvertures (19) au fond desquelles apparaissent les bornes de contact (15) de l'antenne (5).

## Patentansprüche

1. Herstellungsverfahren einer Hybridkarte (1) mit einem Kartenkörper (2), einem Elektronikmodul (7) mit einem IC-Chip (8) und zwei Kontaktbereichen (12), und einer über zwei Kontaktklemmen (15) an den Kontaktbereichen (12) des besagten Moduls (7) angeschlossenen Antenne (5), **dadurch gekennzeichnet, dass** es eine Etappe umfasst, in der man eine Schicht (4) des Kartenkörpers (2) auf die Antenne (5) abformt, und man in der besagten Schicht (4) einen Hohlraum (17) vorsieht, der die besagten Kontaktklemmen (15) erscheinen lässt, gefolgt von einer Etappe, in der man das Elektronikmodul (7) in den Hohlraum (17) des Kartenkörpers (2) einsetzt.

2. Verfahren nach Anspruch 1, **dadurch gekennzeichnet, dass** man zuerst die Antenne (5) auf einer Thermoplastfolie (3) des Kartenkörpers (2) anordnet, um so eine Anordnung (16) Thermoplastfolie/Antenne zu bilden.

3. Verfahren nach Anspruch 2, **dadurch gekennzeichnet, dass** die Antenne auf der Thermoplastfolie (3) in Form einer Spirale angeordnet ist, deren Enden, d.h. die Kontaktklemmen (15), einander gegenüberliegen, eine innerhalb und eine außerhalb der besagten Spirale.

4. Verfahren nach Anspruch 2 oder 3, **dadurch gekennzeichnet, dass** die auf der Thermoplastfolie (3) angeordnete Antenne (5) per Verkleben auf der besagten Folie (3) befestigt ist.

5. Verfahren nach einem der Ansprüche 2 oder 3, **dadurch gekennzeichnet, dass** die Antenne (5) durch das Auftragen eines Haftpromotors auf die besagte Thermoplastfolie (3) durch Siebdruck und Metallisierung per chemischem Auftrag auf der Thermoplastfolie (3) angeordnet ist.

6. Verfahren nach einem der vorangehenden Ansprüche, **dadurch gekennzeichnet, dass** die Antenne (5), mit Ausnahme ihrer Kontaktklemmen (15), mit einem wärmeaktivierbaren Klebstoff (6) beschichtet wird.

7. Verfahren nach einem der vorangehenden Ansprüche, **dadurch gekennzeichnet, dass** die Schicht (4) auf die Anordnung (16) Thermoplastfolie/Antenne abgeformt wird, in dem man eine Form mit einem Kern verwendet, der die Kontaktklemmen (15) der Antenne (5) abdeckt.

8. Verfahren nach einem der vorangehenden Ansprüche, **dadurch gekennzeichnet, dass** man den Hohlraum (17) mit einer von Löchern (19) durchsetzten Ebene (18) bildet, an deren Boden die Kontaktklemmen (15) der Antenne (5) erscheinen.

## Claims

1. A method of manufacturing a hybrid card (1) comprising a card body (2), an electronic module (7) comprising an integrated circuit chip (8) and two contact areas (12), and an antenna (5) connected to the contact areas (12) of the said module (7) by means of two contact terminals (15), **characterised in that** it comprises a step according to which a layer (4) of the card body (2) is moulded onto the antenna (5) and there is provided, in the said layer (4), a cavity (17) revealing the said contact terminals (15) of the antenna (5), followed by a step according to which the electronic module (7) is attached in the cavity (17) of the card body.

2. A method according to Claim 1, **characterised in that** the antenna (5) is first disposed on a thermoplastic sheet (3) of the card body (2) so as to form an assembly (16) : thermoplastic sheet/antenna.

3. A method according to Claim 2, **characterised in that** the antenna is disposed on the thermoplastic sheet (3) in the form of a spiral whose ends, that is to say the contact terminals (15), are located opposite each other, one inside and the other outside the said spiral.

4. A method according to Claim 2 or 3, **characterised in that** the antenna (5) disposed on the thermoplastic sheet (3) is fixed to the said sheet (3) by gluing.

5. A method according to one of Claims 2 or 3, **characterised in that** the antenna (5) is disposed on the thermoplastic sheet (3) by the deposition of an adhesion promoter on the said thermoplastic sheet (3) by screen printing and then metallisation by chemical deposition.

6. A method according to any one of the preceding claims, **characterised in that** the antenna (5), with the exception of its contact terminals (15), is coated with a heat-activated glue (6).

7. A method according to one of the preceding claims, **characterised in that** the layer (4) is moulded onto the assembly (16) consisting of thermoplastic sheet and antenna by moulding, using a mould comprising a core covering the contact terminals (15) of the antenna (5).

8. A method according to any one of the preceding claims, **characterised in that** the cavity (17) is formed with a surface (18) with openings (19), at the bottom of which the contact terminals (15) of the antenna (5) appear.
